# EUROPÄISCHE PATENTSCHRIFT

(11) **EP 2 291 868 B1**
(45) Veröffentlichungstag und Bekanntmachung des Hinweises auf die Patenterteilung: **22.04.2020**
(21) Anmeldenummer: 09741903.0
(22) Anmeldetag: 08.05.2009
(51) Int. Cl.: H01L 31/18

(54) **VORRICHTUNG UND VERFAHREN ZUM TEMPERN VON GEGENSTÄNDEN IN EINER BEHANDLUNGSKAMMER**
DEVICE AND METHOD FOR TEMPERING OBJECTS IN A TREATMENT CHAMBER
DISPOSITIF ET PROCÉDÉ DE RÉGULATION DE TEMPÉRATURE D'OBJETS DANS UNE CHAMBRE DE TRAITEMENT

(30) Priorität: 08.05.2008 DE 102008022784
(43) Veröffentlichungstag der Anmeldung: 09.03.2011
(73) Patentinhaber: (CNBM) Bengbu Design & Research Institute for Glass Industry Co., Ltd., Bengbu (CN)
(72) Erfinder: PALM, Jörg, 80797 München (DE); BAUMBACH, Jörg, 81669 München (DE); KARG, Franz, 80689 Munchen (DE); FÜRFANGER, Martin, 85643 Steinhöring (DE)
(74) Vertreter: Gebauer, Dieter Edmund
(86) Internationale Anmeldenummer: PCT/EP2009/003301
(87) Internationale Veröffentlichungsnummer: WO 2009/135685

(56) Entgegenhaltungen:
- WO-A2-01/09961
- WO-A2-01/29901
- US-A1- 2003 038 127
- US-A1- 2005 115 947

## Beschreibung

Die vorliegende Erfindung betrifft eine Vorrichtung zum Tempern von Gegenständen gemäß Oberbegriff von Anspruch 1 und ein Verfahren zum Tempern von Gegenständen gemäß Oberbegriff von Anspruch 13.

Temperverfahren werden bei Gegenständen in vielfältiger Art und Weise eingesetzt, um bestimmte chemische und/oder physikalisch Eigenschaften einzustellen, beispielsweise bei Dünnschichtsolarzellen.

So zählen Solarmodule auf der Basis von Chalkopyrithalbleitern (z.B. CuInSe₂, abgekürzt "CIS") zu den aussichtsreichsten Kandidaten für wesentlich kostengünstigere Solarstromanlagen. Solche Dünnschichtsolarmodule weisen zumindest ein Substrat (z.B. Glas, Keramik, Metall- oder Kunststofffolie), eine erste Elektrode (z.B. Mo oder ein Metallnitrid), eine Absorberschicht (z.B. CuInSe₂ oder allgemeiner (Ag, Cu)(In, Ga, Al)(Se,S)₂), eine Frontelektrode (z.B. ZnO oder SnO₂) und Verkapselungs- und Abdeckmaterialien (z.B. EVA/Glas oder PVB/Glas, wobei EVA für Ethylen-Vinylacetat und PVB für Polyvinylbutyral steht) als wesentliche Bestandteile auf, wobei die im Folgenden jeweils die chemischen Zeichen für bestimmte Elemente angegeben werde, beispielsweise "Mo" für Molybdän oder "Se" für Selen. Weitere Schichten, wie z.B. Alkalibarrierenschichten zwischen Glas und Mo oder Pufferschichten zwischen Absorber und Fensterschicht können eingesetzt werden, um den Wirkungsgrad und/oder die Langzeitstabilität zu verbessern. Wesentlicher weiterer Bestandteil eines typischen Dünnschichtsolarmoduls ist die integrierte Serienverschaltung, die aus Einzelsolarzellen eine serienverschaltete Kette bildet und damit höhere Betriebsspannungen ermöglicht.

Die Herstellung der Halbleiterabsorberschicht (z.B. CIS) benötigt die höchsten Prozesstemperaturen, erfordert die genaueste Kontrolle von Prozessatmosphäre und Temperatur und gilt deshalb als der anspruchsvollste und teuerste Teil der gesamten Prozesssequenz zur Herstellung eines CIS-Solarmoduls. Unterschiedliche Verfahren wurden dafür bisher eingesetzt die im Wesentlichen in zwei Kategorien einzuteilen sind: a) Einstufenverfahren (z.B. Koverdampfung) und b) Zweistufenverfahren.

Typisches Merkmal von Einstufenverfahren ist die simultane Beschichtung aller Einzelelemente und die Kristallbildung bei hoher Temperatur. Dies führt zu großen, zum Teil konträren Herausforderungen sowohl für die Prozessführung, z.B. gleichzeitige Kontrolle von Schichtzusammensetzung, Dotierung (durch Natrium), Kristallwachstum, Glasverbiegung, Einhaltung großflächiger Homogenität, als auch für die Anlagentechnik, z.B. Verdampfertechnologie für Cu mit hohem Schmelzpunkt und für korrosives Se, Prozessierung im Hochvakuum, Homogenität der Glaserhitzung, hoher Durchsatz und Anlagenverfügbarkeit, d.h. Kontrolle von Partikelgeneration, etc. Die Realisierung von ausreichend kostengünstigen und zuverlässigen Fertigungsprozessen ist dadurch erschwert.

Bei den Zweistufenverfahren erfolgt eine Trennung von Beschichtung und Kristallbildung. Nach einer vorausgegangenen Beschichtung der Metallkomponenten (den so genannten Vorläuferschichten, z.B. Cu und In) und gegebenenfalls von Se nahe Raumtemperatur erfolgt die Schichtbildung bei Temperaturen von bis zu 600°C in einer oder mehreren, von der Beschichtung getrennten Prozesskammern. Während der Beschichtungsteil nahe Raumtemperatur mit herkömmlichen und erprobten PVD-Prozessen schnell und kostengünstig realisierbar ist, erfordert der zweite Prozessteil für die Temperaturbehandlung in der Regel Spezialanlagen. Zur Herstellung qualitativ hochwertiger Chalkopyrithalbleiter müssen diese Spezialanlagen ausgelegt sein, eine homogene und schnelle Aufheizung bzw. Abkühlung großer beschichteter Substrate zu leisten, einen ausreichend hohen, kontrollierbaren und reproduzierbaren Partialdruck der Chalkogenelemente (Se und/oder S) zu gewährleisten, eine Sauerstoff und Wasserdampf freie und partikelarme Prozessatmosphäre sicherzustellen. Dabei sollen weiterhin ein geringer Wartungsaufwand und hohe Anlagenverfügbarkeit gegeben sein und es soll eine möglichst geringe Kondensation von flüchtigen Komponenten oder Korrosion durch Se- oder S-Verbindungen erfolgen und die Umgebung vor toxischen Prozesskomponenten und Prozessmaterialien geschützt sein. Schließlich sollen geringe Investitionskosten bestehen.

Der historisch erste Zweistufenprozess, mit dem eine Solarmodulfertigung aufgebaut wurde, startete mit gesputterten Vorläuferschichten aus Cu, Ga und In auf Glassubstraten, z.B. gemäß US 4,798,660. In einem Rohrofen wurden anschließend Pakete ("Batches") dieser Substrate einem reaktiven Temper- und Kristallbildungsprozess in einer Atmosphäre aus H₂Se (in der ersten Phase des Prozesses) und H₂S (in der zweiten Phase) ausgesetzt (eine erste Form dieses Prozesses wurde erstmals beschrieben in D. Tarrent, J. Ermer, Proc. 23rd IEEE PVSC (1993) p. 372-378). Obwohl damit die ersten kommerziellen Chalkopyritsolarmodule hergestellt wurden, muss die Homogenität der damit hergestellten Halbleiterschichten und damit der Wirkungsgrad der Solarmodule für künftige Erfordernisse verbessert werden. Außerdem ist die Übertragung dieses Konzeptes auf eine Massenfertigung nur schwer realisierbar.

Die weltweit höchsten Wirkungsgrade auf großen Solarmodulflächen wurden ebenfalls mit einem Zweistufenprozess realisiert, bei dem allerdings als Vorläuferschicht nicht nur Cu, Ga und In, sondern auch Se in elementarer Form auf einem Substrat mit PVD-Verfahren abgeschieden wird und anschließend in einem schnellen Temperprozess (teilweise unter Zusatz eines S-haltigen Prozessgases) zur Reaktion gebracht wird. Die grundlegenden Verfahrensbestandteile sind z.B. in EP 0 662 247 (einem grundlegenden Patent zur RTP- ("rapid thermal processing") Selenisierung) beschrieben. Wesentlich daran ist a) die schnelle Erhitzung des Substrates und b) ein minimierter Prozessraum, der den Verlust an flüchtigen Chalkogenkomponenten (Se und/oder S) und deren flüchtigen Reaktionsprodukte mit den Metallkomponenten verhindert. Die praktische Ausgestaltung und Verbesserung des Konzepts eines volumenminimierten Reaktionsbehälters und der Aufbau einer darauf basierenden Fertigungsanlage sind z.B. in EP 1 258 043 (Selenisierungsbox) und WO 01/29901 A2 (Kammeraufbau der Selenisierungsanlage) beschrieben.

Obwohl mit den beiden zuletzt genannten bekannten Konzepten eine Solarmodul-Fertigung möglich ist, ist die Übertragung dieses Konzepts auf noch größere Kammern mit höherem Durchsatz und damit die erforderliche weitere Kostensenkung dieser Fertigungsanlagen erschwert.

US 2005/115947 A1 offenbart eine Vorrichtung zum thermischen Prozessieren eines Substrats. Zum Schutz der Vorrichtung vor Bruchstücken wird das Substrat durch eine Haube abgedeckt.

US 2003/038127 A1 offenbart eine Vorrichtung zum thermischen Prozessieren eines Werkstücks, wobei die Menge an notwendigem Prozessgas oder Spülgas durch eine Eingrenzung des Prozessraums um das Werkstück reduziert wird.

Der vorliegenden Erfindung liegt daher die Aufgabe zugrunde, eine Vorrichtung und ein Verfahren zur Temperierung von Gegenständen bereitzustellen, die die oben genannten Nachteile bekannter Ofenkonzepte überwindet, wobei insbesondere eine hohe Reproduzierbarkeit und ein hoher Durchsatz der Temperierung erreicht werden sollen, bei gleichzeitig möglichst geringen Investitionskosten, so dass der Prozess der Temperierung insgesamt kostengünstiger realisiert werden kann.

Diese Aufgabe wird erfindungsgemäß mit einer Vorrichtung gemäß Anspruch 1 und einem Verfahren gemäß Anspruch 13 gelöst. Vorteilhafte Weiterbildungen sind jeweils in den abhängigen Unteransprüchen angegeben.

Überraschender Weise hat sich gezeigt, dass die oben angegebene Aufgabe dadurch gelöst werden kann, wenn der gegenüber dem Kammerraum der Behandlungskammer minimierte Prozessraum erst innerhalb der Temperierungskammer selbst hergestellt wird und nicht schon vor Einbringung des Gegenstands in die Temperierungskammer, wie es beispielsweise in der EP 1 258 043 beschrieben wurde. Es handelt sich also um eine nur temporäre Einhausung zumindest des zu tempernden Teils des Gegenstands. Die temporäre Einhausung während des Temperprozesses ist nicht nur wichtig für eine definierte Prozessführung (z.B. Erhalt des Partialdruck der Chalkogenkomponenten), sondern reduziert auch die Exposition der Reaktionskammer mit korrosiven Prozessgasen oder gasförmigen korrosiven Reaktionsprodukten.

Durch die temporäre Einhausung wird zum einen der Einsatz geschlossener Prozessboxen vermieden, die vor der Einführung des Gegenstands in die Temperierungskammer für jeden einzelnen Gegenstand bzw. eine Reihe von Gegenständen vorzusehen sind. Dadurch werden zum einen die Kosten reduziert und zum anderen die Reproduzierbarkeit erhöht, da selbst bei genauester Fertigung der Prozessboxen übliche Fertigungstoleranzen bestehen und sich die Prozessboxen über lange Zeit aufgrund der Prozesswirkung geringfügig unterschiedlich verändern können, wodurch insgesamt keine exakt übereinstimmenden Prozessräume sichergestellt werden können. Zum anderen erlaubt die Verwendung einer temporären Einhausung eine effektivere Abkühlung des Substrates als bei Prozessboxen, denn bei Verwendung von permanenten Prozessboxen ist eine schnelle Abkühlung des Gegenstands aufgrund der reduzierten Konvektion nicht erreichbar. Zur Vermeidung von Verbiegungen des Gegenstands müssen insbesondere beide Seiten des Gegenstands gleichmäßig abgekühlt werden. Dies ist bei einer permanenten Box im Kühlbereich nur mit geringen Raten möglich. Bei einer temporären Box kann im Kühlbereich direkt die Gegenstandsoberseite und der Träger des Gegenstands bzw. die Gegenstandsunterseite gekühlt werden, so dass deutlich höhere Kühlraten möglich sind.

Die erfindungsgemäße Vorrichtung und das erfindungsgemäße Verfahren lassen sich ganz allgemein und grundsätzlich zur Temperaturbehandlung von Gegenständen, insbesondere großflächiger, beschichteter Substrate, in einer Inert- oder Reaktivgasatmosphäre unter annähernd Normaldruckbedingungen einsetzen. Sie ermöglichen eine schnelle Temperung unter definiertem Partialdruck von gasförmigen Komponenten und vermeiden die Korrosion der Behandlungskammermaterialien auch im Langzeiteinsatz.

Die erfindungsgemäße Vorrichtung zum Tempern zumindest eines Gegenstands, insbesondere eines Mehrschichtkörpers mit mindestens zwei Schichten, weist eine Behandlungskammer mit einem Kammerraum, mindestens eine Energiequelle und eine Prozesshaube auf, die einen Prozessraum definiert, in dem der Gegenstand zumindest teilweise anordenbar ist, wobei die Prozesshaube das Volumen des Prozessraumes, in dem zumindest ein Teil des Gegenstands temperiert wird, gegenüber dem Volumen des Kammerraumes reduziert. Dabei ist die Prozesshaube zumindest als stationär in der Behandlungskammer angeordneter Deckel ausgebildet. Der Gasaustausch zwischen Prozessraum und Kammerraum ist daher gegenüber größer ausgelegten Prozessräumen bzw. gegenüber Prozessräumen ohne Prozesshaube deutlich reduziert. Möglich ist es auch, unter bestimmten Voraussetzungen, dass in Bezug auf die Größe des Prozessraumes im Wesentlichen kein Gasaustausch zwischen Prozessraum und Kammerraum stattfindet.

Der Deckel kann entweder als separat in der Behandlungskammer angeordnetes Element oder in Form einer oder mehrere Wände der Behandlungskammer ausgebildet sein. Stationär in diesem Zusammenhang bedeutet nur, dass die Prozesshaube während aufeinander folgender Temperprozesse an verschiedenen Gegenständen in der Behandlungskammer verbleibt und nur für Wartungs- bzw. Reparaturmaßnahmen entnommen wird. Die Prozesshaube kann dabei allerdings in der Behandlungskammer beweglich, insbesondere bei Durchlaufanlagen in einer Richtung senkrecht zur Gegenstandstransportrichtung ausgebildet sein, sie muss es allerdings nicht, d.h. es reicht auch, wenn der Gegenstand in einem bestimmten Abstand unter der Prozesshaube angeordnet wird, weil dadurch der Prozessraum gegenüber dem Kammerraum reduziert wird.

Das Volumen des Prozessraumes wird im Wesentlichen von der Fläche des Gegenstandes (zum Beispiel einem Glassubstrat) oder der Fläche des Substratträgers und der Höhe des Deckels über dem Substrat, d.h. dem Abstand zwischen Substratoberseite und Deckelunterseite bestimmt. Der Abstand sollte weniger als 50mm, bevorzugt weniger als 10mm betragen. In der Praxis kann ein minimaler Abstand erforderlich sein, wenn der Deckel den Gegenstand nicht berühren darf und der Gegenstand Unebenheiten aufweist oder sich₁ wie beispielsweise ein Glassubstrat₁ durch das Aufheizen verbiegt. In der Praxis könnte daher ein Abstand von 1 mm bis 8mm vorteilhaft sein. Ein noch geringerer Abstand könnte für Foliensubstrate oder sehr dünne Glasscheiben vorteilhaft sein.

Der Abstandshalter kann auch fester Bestandteil des Trägers sein, derart dass der Deckel auf dem Rahmen aufliegt und so den Gasaustausch zwischen dem Prozessraum und dem Kammerraum deutlich reduziert.

Es muss für die vorliegende Erfindung keine vollständige Abdichtung zwischen Prozessraum und Kammerraum bestehen. Es müssen sich zwischen Prozessraum und Kammerraum eine Gasaustauschbarriere oder ein Druckausgleichswiderstand ausbilden, die verhindern, dass verdampfende Schichtkomponenten, Prozessgase bzw. Prozessreaktionsgase in den Kammerraum in Bezug auf die gesamte Prozessgas- bzw. Prozessreaktionsgasmenge in unkontrollierter Menge übertreten. In der einfachsten Ausgestaltung bildet bereits bei großen Substraten ein sehr kleiner Abstand zwischen dem Deckel und dem Substrat oder einem Träger eine Gasaustauschbarriere, die den Austritt flüchtiger Komponenten aus dem Prozessraum deutlich reduziert, insbesondere dann, wenn die freie Weglänge gering ist (zum Beispiel durch Prozessierung nahe Normaldruck). Natürlich können aber besondere Abdichtungsmaßnahmen vorgesehen sein, wie ein abdichtender Rahmen, die einen Druckausgleichswiderstand ausbilden, um einen Gasaustausch weitgehend oder vollständig zu verhindern, selbst dann, wenn der Gesamtdruck im Prozessraum zeitweise größer als der Druck im Kammerraum ist. Der Druckausgleichswiderstand oder die Gasaustauschbarriere müssen mindestens derart ausgestaltet sein, dass der Massenverlust der Chalcogenkomponenten (S, Se) aus dem Prozessraum durch Verdampfen und Ausdiffusion kleiner als 50%, bevorzugt 20% und optimal kleiner 10% ist. Kleinere Verluste können durch ein höheres Angebot ausgeglichen werden. Größere Verluste sind auch nachteilig hinsichtlich der Materialkosten und der Belastung des Kammerraumes durch die korrosive Chalcogene oder deren Verbindungen.

Erfindungsgemäß weist der Deckel einen umlaufenden Rahmen auf, der so dimensioniert ist, dass der Gegenstand oder ein den Gegenstand stützender Träger seitlich umhüllbar ist, wobei der Rahmen bevorzugt gegenüber dem Gegenstand bzw. dem Träger seitlich verschiebbar angeordnet ist ( d.h. dass beispielsweise bei einer vertikalen Anordnung des Deckels über dem Gegenstand der Rahmen außen an den äußeren Seiten des Gegenstands bzw. des Trägers vorbei bewegbar ist). Dadurch wird erreicht, dass der Abstand zwischen Deckel und Gegenstandsoberfläche variabel einstellbar und somit der Temperprozess in Bezug auf den Gegenstand und dessen gewünschte chemische und/oder physikalische Eigenschaften definiert einstellbar ist. Dieser Rahmen kann für größere Gegenstände bzw. Träger auch gleichzeitig als Abstandshalter dienen. Statt eines solchen seitlich am Gegenstand bzw. dessen

Träger vorbei verschiebbar ausgebildeten Rahmens kann auch ein als Abstandshalter ausgebildeter Rahmen vorgesehen sein, der in Bezug auf den Deckel verschiebbar ausgebildet ist. Auch dann ist der Abstand zwischen Deckel und Gegenstandsoberfläche trotz im Wesentlichen Aufliegens des Abstandshalters auf der Oberfläche des Gegenstands bzw. dessen Trägers definiert einstellbar.

Vorzugsweise bilden die Prozesshaube und der Gegenstand oder der Träger eine Gasaustauschbarriere aus, die den Gasaustausch zwischen dem Prozessraum und dem Kammerraum derart reduziert, dass der Massenverlust von im Aufheizprozess abdampfenden Materialkomponenten des Gegenstandes kleiner als 50 %, bevorzugt kleiner als 20 % ist und idealerweise unter 10 % liegt.

In einer weiteren bevorzugten Ausführungsform bildet der Prozessraum, der durch die Prozesshaube und den Gegenstand oder den Träger gebildet wird, einen Druckausgleichswiderstand zum Kammerraum aus.

Weiterhin sind vorzugsweise die Prozesshaube und der Gegenstand oder der Träger derart ausgebildet, dass der Prozessraum, der durch die Prozesshaube und den Gegenstand oder den Träger gebildet wird, im Wesentlichen gasdicht abgedichtet ist. Dies kann heißen, dass in Bezug auf die Größe des Prozessraums im Wesentlichen kein Gasaustausch zwischen Prozessraum und Kammerraum stattfindet.

Vorteilhaft weist die Prozesshaube zumindest einen Gaseinlass und/oder zumindest einen Gasauslass auf, wobei die Prozesshaube bevorzugt einen zweidimensional ausgebildeten Gasverteiler aufweist. Durch Gaszu- und abfluss kann der Partialdruck bestimmter Kornponenten im Prozessgas bzw. Prozessreaktionsgas definiert eingestellt werden. Mit dem zweidimensional ausgebildeten Gasverteiler lässt sich der Partialdruck besonders homogen einstellen. Ein zweidimensional ausgebildeter Gaseinlass empfiehlt sich besonders für Prozesse oder Teilprozessphasen, bei denen der Verlust gasförmiger Komponenten aus der Ausgangsschicht oder deren Reaktionsprodukte weniger kritisch ist, da sonst die Löcher für die Gasdurchführung wiederum den Verlust dieser gasförmiger Komponenten oder Reaktionsprodukte aus dem Prozessraum erhöhen. Vorteilhaft wird durch die Kombination einer stationären Prozesshaube mit dem Gaseinlass bzw. Gasauslass erreicht, dass Ankopplungsmittel, wie sie in WO 01/09961 A2 erforderlich und gezeigt sind, nicht notwendig sind, wodurch zum einen die Haltbarkeit der Vorrichtung und zum anderen auch die Reproduzierbarkeit der Temperierung verbessert werden.

Der Partialdruck der gasförmigen Komponenten wird einerseits durch die Temperatur und die bereitgestellten Stoffmengen und anderseits durch den Verlust der gasförmigen Komponenten aus dem Prozessraum bestimmt. Der Gesamtverlust wird durch die freie Weglänge der gasförmigen Komponenten bei gegebenem Gesamtdruck und Temperatur und die geometrischen Randbedingungen, d.h. durch die Höhe des Prozessraumes gegenüber dem Gegenstand, der Größe des Gegenstands und der Dichtigkeit des Prozessraums gegenüber einem Gasübertritt und den Kammerraum bestimmt. Durch die Wahl der Prozessparameter sowie die Dimensionierung und Ausführung der Einhausung des Gegenstands kann der Partialdruck wichtiger prozessrelevanter gasförmiger Komponenten daher besser kontrolliert werden (z.B. der Partialdruck der Chalkogenkomponenten Se und S bei Herstellung von CIS-Solarzellen). Insbesondere kann durch Minimierung des Gasraums erreicht werden, dass im Prozess entstehende flüssige Phasen noch im thermischen Gleichgewicht mit ihrem Dampfdruck stehen können und nicht vollständig in das sehr viel größere Volumen der Reaktionskammer abdampfen. Diese Erfindung umfasst alle Ausgestaltungen, in denen der Gasaustausch zwischen dem durch die Haube gebildeten Prozessraum und dem Kammerraum deutlich reduziert ist. Zusätzliche Prozessgase (wie Stickstoff, Schwefelwasserstoff), die vor oder während des Prozesses eingelassen werden, können jedoch unter Umständen aus dem Prozessraum durch die verbleibenden Spalte auch in größeren Mengen austreten, wenn der Gesamtdruck durch das Aufheizen und Tempern über den Totaldruck des Kammerraumes steigt. Eine wirklich gasdichte Ausgestaltung ist nur eine mögliche der hier dargestellten Ausgestaltungen. Wesentlich für alle erfindungsgemäßen Ausgestaltungen ist die Reduktion des Verlustes der erst im Aufheizprozess teilweise verdampfenden Schichtkomponenten (beispielsweise Se und S). Deren Massenverlust sollte geringer als 20% sein.

Bevorzugt ist die Energiequelle außerhalb des Reaktionsraumes angeordnet und bevorzugt als Strahlungsquelle für elektromagnetische Strahlung und insbesondere als eine einzelne Strahlungsquelle oder als Anordnung mehrerer punktförmiger Strahlungsquelle ausgebildet, wobei die Strahlungsquelle bevorzugt mit einem Reflektor auf der der Reaktionskammer der Strahlungsquelle abgewandten Seite versehen ist. Die Verlagerung der Heizelemente (einschließlich der optionalen Reflektoren) nach außen erlaubt einen schnelleren Austausch defekter Heizelemente im laufenden Betrieb, ermöglicht den Einsatz effizienterer und kostengünstigeren Reflektoren, die nicht mit den korrosiven Prozessgasen in Berührung kommen und dadurch auch nicht korrodieren können (z.B. metallische Reflektoren, gekühlte Reflektoren). Außerdem kann unter Umständen beim Einsatz einer Vielzahl von Punktheizelementen trotz Ausfalls einzelner Punktheizelementen die Temperierung fortgeführt werden, wenn insgesamt noch eine ausreichend homogene Temperierung des Gegenstands sichergestellt ist.

Weiterhin ist es bevorzugt, wenn die Prozesshaube zumindest teiltransparent für elektromagnetische Strahlung ausgebildet ist und/oder zumindest eine Wand der Behandlungskammer zumindest bereichsweise zumindest teiltransparent für elektromagnetische Strahlung ausgebildet ist, wobei bevorzugt zumindest teiltransparent für elektromagnetische Strahlung ausgebildete Segmente in einem Stützrahmen aufgenommen sind. Dann kann die Energie der Energiequellen direkt durch Wärmestrahlung wirken, wobei die Energiequellen entweder innerhalb oder außerhalb der Behandlungskammer angeordnet sein können.

Vorteilhaft ist zumindest eine Wand der Behandlungskammer mit einer Beschichtung und/oder Verkleidung versehen, die eine Belegung der Kammerwand oder die Einwirkung von korrosiven Gasen und Dämpfen auf sie im Wesentlichen verhindern, wobei die Kammerwand bevorzugt so heizbar ausgerüstet ist, dass eine Belegung mit flüchtigen Komponenten im Wesentlichen verhindert wird. Dadurch wird der Betrieb der Behandlungskammer über große Zeit im Wesentlichen ohne Wartungszeiten ermöglicht.

Weiterhin ist es bevorzugt, wenn die Behandlungskammer ausgelegt ist, zwei oder mehrere Gegenstände gleichzeitig zu tempern, wobei entweder eine gemeinsame Prozesshaube oder für jeden Gegenstand eine eigene Prozesshaube vorgesehen ist.

Außerdem können zumindest zwei Behandlungskammern zum Tempern in Transportrichtung des Gegenstandes hintereinander angeordnet und/oder zumindest eine Einrichtung zum Kühlen des Gegenstandes vorgesehen sein, wobei die Kühleinrichtung bevorzugt in einer von der Behandlungskammer unabhängigen Kühlkammer angeordnet ist.

Selbständiger Schutz wird beansprucht für ein Verfahren zum Tempern zumindest eines Gegenstands, insbesondere eines Mehrschichtkörpers mit mindestens zwei Schichten, in einer Behandlungskammer mit einem Kammerraum, insbesondere unter Verwendung der erfindungsgemäßen Vorrichtung zum Tempern, wobei der Gegenstand in die Behandlungskammer gebracht und zumindest bereichsweise einer Energiequelle ausgesetzt wird, wobei in der Behandlungskammer zumindest bereichsweise um den Gegenstand ein Prozessraum angeordnet ist, der kleiner als der Kammerraum ist. Dabei wird der Prozessraum erst im Inneren der Behandlungskammer ausgebildet. D. h. dass keine von außen der Behandlungskammer mit dem Gegenstand zuführbare Prozessbox verwendet wird, sondern dass die zumindest teilweise Einhausung des Gegenstands erst innerhalb der Behandlungskammer erfolgt und die Mittel zur Einhausung in der Behandlungskammer vor Einführung des Gegenstands in und nach Entnahme des Gegenstands aus der Behandlungskammer verbleiben. Vorteilhaft wird dabei der Prozessraum so eingestellt, dass der Prozessraum körperlich vom Kammerraum zumindest durch einen Druckausgleichswiderstand begrenzt wird.

Der Gasaustausch zwischen Prozessraum und Kammerraum ist deutlich reduziert, ggf. findet in Bezug auf die Größe des Prozessraums im Wesentlichen kein Gasaustausch zwischen Prozessraum und Kammerraum statt.

Für dieses Verfahren ist die Verwendung von Spülgas für den Kammerraum und die Einstellung eines definierten Druckgradienten zur Erzeugung einer Spaltgegenstrom-Spülung zweckmäßig, wie sie aus der WO 01/29901 A2 bekannt sind, wozu der diesbezüglich Inhalt der WO 01/29901 A2 durch Referenznahme vollständig mit in die vorliegende Erfindung einbezogen wird. Hierdurch wird ein Gasübertritt aus dem Prozessraum in den Kammerraum wirksam verhindert. Dafür ist dann die Bereitstellung eines den Prozessraum umgebenden Pufferraums erforderlich, der in Gasdurchtrittsrichtung zwischen Kammerraum und Prozessraum angeordnet ist, wobei der Pufferraum mit einem Gasauslass verbunden ist, der die Gase direkt aus der Behandlungskammer ableitet, d.h. dass die aus dem Pufferraum abgeleiteten Gase nicht in den Kammerraum eintreten.

Die Merkmale der vorliegenden Erfindung sowie die Vorteile werden nachfolgend mit Hilfe einiger Ausführungsbeispiele im Zusammenhang mit der Zeichnung näher verdeutlicht.

Dabei zeigen
- Fig. 1: eine erste Ausführungsform der erfindungsgemäßen Vorrichtung im Querschnitt,
- Fig. 2: die Ausführungsform gemäß Fig. 1 in einer Draufsicht,
- Fig. 3: die Prozesshaube gemäß Fig. 1 in einer detaillierten Ansicht,
- Fig. 4: die Prozesshaube in einer ersten alternativen Ausgestaltung,
- Fig. 5: die Prozesshaube in einer zweiten alternativen Ausgestaltung,
- Fig. 6: die Prozesshaube in einer dritten alternativen Ausgestaltung nicht Teil der Erfindung,
- Fig. 7: die Prozesshaube in einer vierten alternativen Ausgestaltung,
- Fig. 8: eine erfindungsgemäße Vorrichtung mit der Teilansicht der Kühlstrecke,
- Fig. 9: die Transporteinrichtung für die erfindungsgemäße Vorrichtung,
- Fig. 10: die schematische Ansicht einer ersten Gesamtanlage, in die die erfindungsgemäße Vorrichtung integriert ist und
- Fig. 11: die schematische Ansicht einer zweiten Gesamtanlage, in die die erfindungsgemäße Vorrichtung integriert ist.

Im Folgenden werden dieselben oder gleiche Bezugszeichen für die selben bzw. gleich ausgebildete Merkmale verwendet.

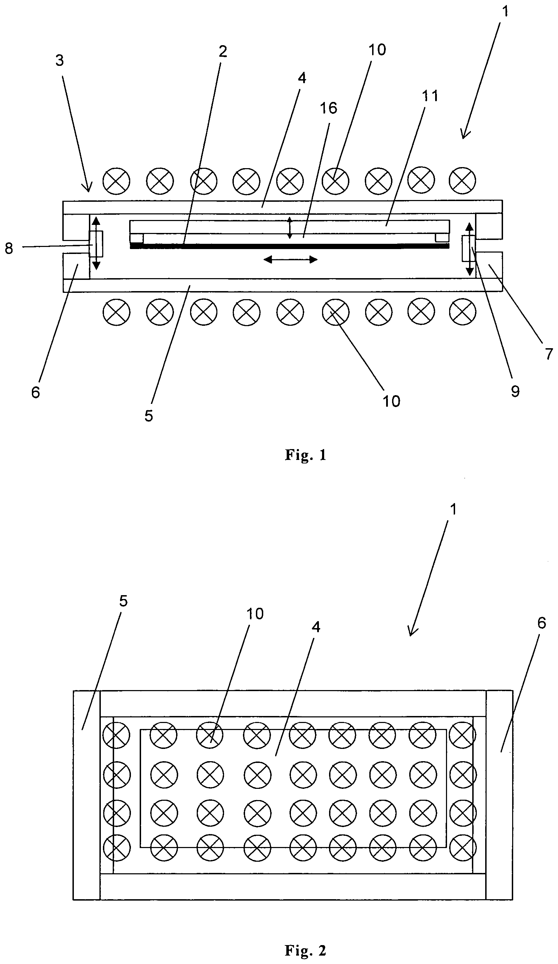

In Fig. 1 bis 3 ist rein schematisch die erfindungsgemäße Vorrichtung 1 in einer ersten bevorzugten Ausgestaltung dargestellt, die angepasst ist, großflächige Substrate 2 zu tempern. Zu erkennen ist, dass die Vorrichtung 1 eine Behandlungskammer 3 mit Kammerwänden 4, 5, 6, 7 und einer Eingangstür 8 und einer gegenüberliegenden Ausgangstür 9 aufweist. Zum Transport des Substrates 2 ist eine Transportvorrichtung (nicht gezeigt) vorgesehen, die mit oder ohne einem Träger für das Substrat 2 arbeitet und das Substrat 2 durch die Türen 8, 9 durch die Behandlungskammer 3 transportieren kann. Ober- und unterhalb der Behandlungskammer 3 sind mehrere punktförmige Quellen 10 für elektromagnetische Strahlung matrixartig angeordnet. Zum Durchlass der Strahlung sind der Kammerdeckel 4 und der Kammerboden 5 der Behandlungskammer 3 zumindest bereichsweise zumindest teiltransparent ausgebildet, um eine homogene Energieeinwirkung auf das Substrat 2 zu ermöglichen.

Im Inneren der Behandlungskammer 3 ist eine Prozesshaube 11 vorgesehen, die einen für die elektromagnetische Strahlung durchlässigen oder zumindest teildurchlässigen Deckel 12 und einen rahmenförmig ausgebildeten Abstandshalter 13 aufweist, der so dimensioniert ist, dass er auf der Peripherie 14 des Substrats 2 mit der Substratbeschichtung 15 aufliegen kann, wenn das Substrat 2 unter der Prozesshaube 11 positioniert ist. Die Prozesshaube 11 ist vertikal gegenüber dem Substrat 2 verschiebbar angeordnet und definiert zwischen sich und dem Substrat 2 einen Prozessraum 16, der weitgehend gegenüber dem Kammerraum 17 abgedichtet ist, so dass während des Temperns im Verhältnis zu den im Prozessraum 16 enthaltenen Prozessgasen und Prozessreaktionsgasen nahezu kein Gas in den Kammerraum 17 übertritt. Die Höhe des Prozessraumes 16, d.h. der Abstand zwischen Deckel 12 und beschichtetem Substrat 2 kann durch vertikale Bewegung des Deckels 12 zum Substrat 2 eingestellt werden. Prinzipiell ist auch die vertikale Bewegung des Substrats 2 von unten gegen die Prozesshaube 11 denkbar. Die eingezeichneten Doppelpfeile zeigen die Beweglichkeiten der entsprechenden Teile an.

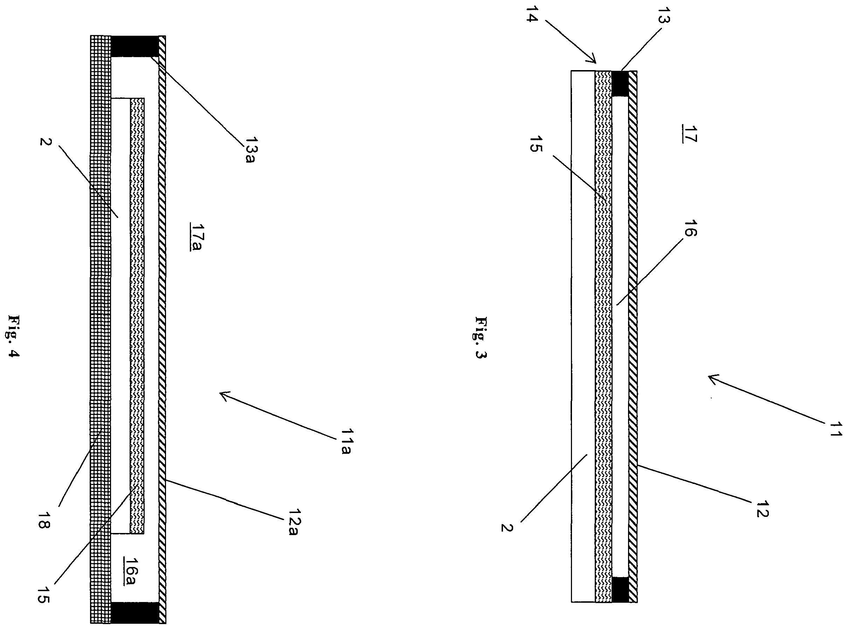

In einer ersten alternativen Ausgestaltung der Prozesshaube 11a gemäß Fig. 4 weist deren Deckel 12a zusammen mit dem Abstandshalterrahmen 13a eine Dimensionierung auf, dass die Prozesshaube 11a bei geringster Annäherung nicht auf der Substratbeschichtung 15 des Substrats 2, sondern auf dem Substratträger 18 zum Aufliegen kommt und damit den Prozessraum 16a vom Kammerraum 17a im Wesentlichen abdichtet.

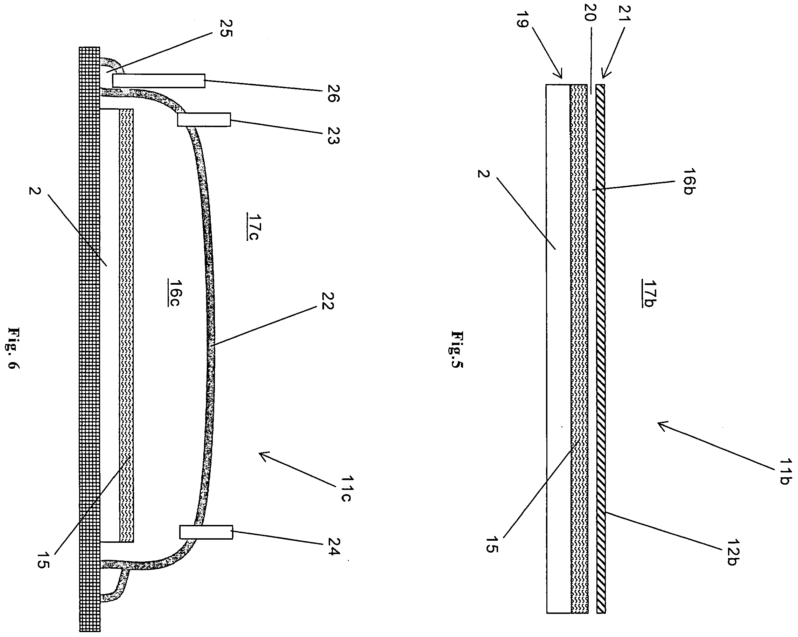

In einer zweiten alternativen Ausgestaltung der Prozesshaube 11b gemäß Fig. 5 weist diese nur einen Deckel 12b auf, der zumindest die gleiche Dimensionierung wie das Substrat 2 besitzt. Zur im Wesentlichen Abdichtung des Prozessraums 16b vom Kammerraum 17b weist der Prozessraum 16b eine im Verhältnis zur lateralen Ausdehnung geringe Höhe auf. Dadurch wirkt der an der Peripherie 19 des Substrats 2 vorhandene Spalt 20 zwischen Substratbeschichtung 15 und der Peripherie 21 des Deckels 12b als Druckwiderstand bzw. Gasaustauschbarriere, wodurch im Verhältnis zum gesamten Prozessraum 16b nur sehr wenig Gas aus diesem in den Kammerraum 17b übertreten kann. Allerdings muss der Deckel 12b nicht parallel zur Oberfläche des Substrats 2 ausgebildet sind, sondern kann auch andere Verläufe, wie einen bogenförmigen aufweisen. Dieser Verlauf der inneren Oberfläche des Deckels 12b kann zur Optimieren des Temperprozesses entsprechend angepasst werden.

In bestimmten Phasen des Temperprozesses sollte der Abstand zwischen Deckel 12, 12a, 12b Substrat in den Ausführungsvarianten gemäß Fig. 3 bis Fig. 5 sehr klein gegenüber den lateralen Abmessungen des Substrates 2 sein. Der Deckel 12, 12a, 12b, die Höhe des Prozessraums 16, 16a, 16b und der Rahmen 13 reduzieren den ungehemmten Abfluss gasförmiger Komponenten aus dem Prozessraum 16, 16a, 16b zwischen dem beschichteten Substrat 2 und dem Deckel 12, 12a, 12b. Die gasförmigen Komponenten können dabei vor oder während des Prozesses zugeführte Prozessgase sein (z.B. H₂S, H₂Se, Se- oder S-Dampf, H₂, N₂, He, oder Ar) oder gasförmige Komponenten und Reaktionsprodukte des beschichteten Substrats. Im speziellen Fall von Cu-In-Ga-Se Vorläuferschichten zum Beispiel Se- oder S-Dampf, gasförmige binäre Selenide, N₂, H₂S oder H₂Se.

In einer dritten alternativen Ausgestaltung der Prozesshaube 11c gemäß Fig. 6 (nicht Teil der Erfindung) wird diese durch einen Glasrezipienten 22 gebildet, der Einlass- und Auslassöffnungen 23, 24 für die Zufuhr von Prozessgas aufweist. Zusätzlich weist die Prozesshaube 11c einen umlaufenden Kanal 25 mit einem Anschluss 26 auf, der in Gasdurchtrittsrichtung zwischen dem Prozessraum 16c und dem Kammerraum 17c angeordnet ist. Gasdurchtrittsrichtung meint hier nur einen möglichen Gasübertritt zwischen Prozessraum 16c und Kammerraum 17c, der nicht erfolgen muss, aber wenn er erfolgt, nur über den Kanal 25 möglich ist.

Durch den Anschluss 26 kann der Kanal 25 dicht an den Substratträger 18 oder das Substrat 2 (nicht gezeigt) gesaugt werden, wenn der Kanal evakuiert (Unterdruck oder Vakuum) wird. Dadurch wird eine optimale Gaseinhausung des Substrates zwischen Prozesshaube 11c und Substratträger 18 erreicht und die Kontamination des Kammerraumes 17c mit Prozessgas und Reaktionsgasen wird vermindert, im Idealfall verhindert. Durch den Zufuhrkanal 23 in der Prozesshaube 11c wird Prozessgas zugeführt und durch den Abluftkanal 24 wird das zugeführte oder entstehende Gasgemisch abgeleitet. Die Effizienz der Gasausnutzung wird durch diese Anordnung gegenüber einer vollständig mit Prozessgas gefüllten Behandlungskammer 1 bedeutend erhöht und somit wird eine Senkung der Produktionskosten gegenüber herkömmlichen Behandlungskammern erreicht. Im Gegensatz zur EP 1 258 043 wird hier die Kontamination des Kammerraumes weiter vermindert und das notwendige Ausmaß der Spülung des Kammerraumes und der Nachbehandlungstechnik minimiert.

Statt den Kanal 25 zu evakuieren, kann dieser auch unter leichten Überdruck durch ein zugeführtes Inertgas gesetzt werden. Das in den Prozessraum 16c durch etwaige Lücken überströmende Inertgas reduziert die Diffusionsverluste von Prozessgas in den Kammerraum 17c.

Die Verwendung eines teiltransparenten Deckels 12, 12a, 12b, 12c erlaubt eine Prozessführung des Heizprozesses gemäß EP 1 258 043 mit kontrollierter Energieeinspeisung von oben und unten in das beschichtete Glassubstrat 2. Wenn ein Substratträger, beispielsweise eine Substratträgerplatte 18 verwendet wird, kann diese teiltransparent oder komplett absorbierend sein.

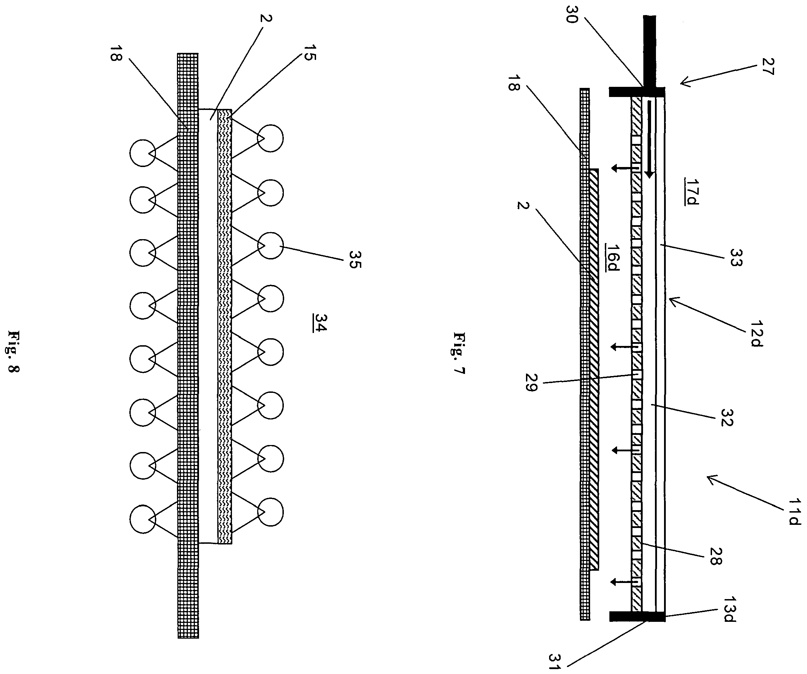

Die Prozesshaube 11d kann auch mit einem zweidimensionalen Prozessgasverteiler 27 gemäß Fig. 7 ausgestattet sein, wobei die Prozesshaube 11d in einer gegenüber dem Substratträger 18d noch nicht geschlossenen Stellung gezeigt ist. Dazu ist der halbtransparenten Deckel 12d doppelwandig ausgeführt. Der untere Deckel 28 enthält kleine Löcher 29 für eine schnelle gleichmäßige Gasverteilung auf großen Substraten 2. Das Gas wird dabei von den Seiten 30, 31 der Prozesshaube 11d in den Zwischenraum 32 zwischen beiden Deckeln 28, 33 geleitet. Der Gasfluss ist reinschematisch mittels Pfeilen dargestellt. Die laterale Gasverteilung im Zwischenraum 32 kann auf Grund des bevorzugt frei wählbaren Abstandes zwischen den beiden Deckelplatten 28, 33 sehr schnell durchgeführt werden. Die Verteilung des Gases über das Substrat 2 wird dann durch das zweidimensionale Netz der kleinen Löcher 29 in der unteren Deckelplatte 28 gewährleistet. Die freie Wählbarkeit des Deckelabstands kann durch einen innerhalb der Prozesshaube 11d gegenüber dem oberen Deckel 33 verschiebbaren unteren Deckel 28 erreicht werden. Alternativ bzw. zusätzlich kann natürlich auch für den Gasauslass ein zweidimensionaler Gasverteiler vorgesehen sein.

Die Verwendung einer temporären Einhausung durch die erfindungsgemäße Prozesshaube 11, 11a, 11b, 11b, 11c, 11d erlaubt im Gegensatz zu EP 1 258 043 eine effektivere Abkühlung des Substrates 2. Bei Verwendung von permanenten Prozessboxen ist stattdessen eine schnelle Abkühlung des Substrats 2 aufgrund der reduzierten Konvektion innerhalb der Box nicht erreichbar. Zur Vermeidung von Verbiegungen des Substrates 2 müssen insbesondere beide Seiten des Substrates 2 gleichmäßig abgekühlt werden. Dies ist bei einer permanenten Box im Kühlbereich nur mit geringen Raten möglich. Im vorliegenden Konzept kann eine homogene und schnelle Abkühlung des Substrats 2 durch den Einsatz von temperierten Kühlplatten und/oder einer erzwungenen Konvektionskühlung erfolgen. Letzteres ist in Fig. 8 dargestellt, wo innerhalb einer Kühlkammer 34 unterhalb und oberhalb des zuvor getemperten Substrats 2 viele einzelne Konvektionskühler 35 angeordnet sind. Natürlich könnten diese Konvektionskühler 35 auch innerhalb der Behandlungskammer 1 zum Tempern angeordnet sein, jedoch wird eine eigene Kühlkammer 34 bevorzugt.

Außerdem kann durch die nur vertikal bewegliche, aber fest in der Anlage installierte Prozesshaube 11, 11a, 11b, 11c, 11d eine zuverlässiger definierte Prozessumgebung gewährleistet werden als durch eine Vielzahl individueller, durch übliche Fertigungstoleranzen leicht unterschiedlicher Prozessboxen.

Die beispielhaft in Fig. 1 gezeigte Anwendung von externen Punktheizquellen 10 ist nicht zwingend erforderlich. Für manche Anwendungen können auch Linienheizelemente gleich vorteilhaft eingesetzt werden. Diese können - wie hier für die Punktlichtquellen 10 vorgeschlagen - außerhalb der Kammer 1 angeordnet werden. Desgleichen wäre die konventionelle Anordnung mit internen Linienheizern kompatibel mit der hier vorgestellten Prozesshaube 11, 1a, 11b, 11c, 11d. Gleichermaßen können anstelle der aus einem Stück gefertigten großflächigen, für die elektromagnetische Strahlung transparenten Kammerwände 4, 5, 6, 7 diese aus transparenten Segmenten zusammengesetzt sein.

Wesentlich an dem hier beschriebenen Kammeraufbau mit externen Heizelementen 10 ist die Abdichtung der transparenten mit den nichttransparenten Kammerwandteilen 4, 5, 6, 7. Damit ist eine gasdichte Abdichtung des mit toxischen Gasen belegten Prozessraumes 17, 17a, 17b, 17c, 17d von dem Kammerraum 16, 16a, 16b, 16c, 16d sichergestellt. Umgekehrt kann der Sauerstoff und Wasserdampfpegel durch einen Spülprozess mit Inertgas (z.B. N₂) zu Beginn des Prozesses und dann für die Dauer des Prozesses minimiert werden

Der Einsatz von Substratträgerplatten (oder Carriern) 18, auf denen die eigentlich zu prozessierenden Substrate 2 abgelegt und durch die Anlage 1 mit transportiert werden, kann sich aus der gewählten Realisierung des Substrattransportes ergeben. Größere Substrate 2 benötigen auf jeden Fall eine mechanische Unterstützung 18 während des Heizprozesses, da Durchbiegungen durch das Eigengewicht des Substrates, beispielsweise eines Glases, nach dem gesamten Heizprozess bis in die Nähe der Glaserweichungstemperatur im anschließendem Kühlprozess zu permanenten Substratverbiegungen eingefroren werden können. Die mechanische Unterstützung des Substrats 2 von unten darf jedoch nicht die homogene Aufheizung von unten behindern. Eine Substratträgerplatte 18 ist jedoch nicht zwingend erforderlich für die erfindungsgemäße Prozesshaube 11, 11a, 11b, 11c, 11d zur Kontrolle der Partialdrücke und auch nicht für den Heizprozess gemäß EP 1 258 043.

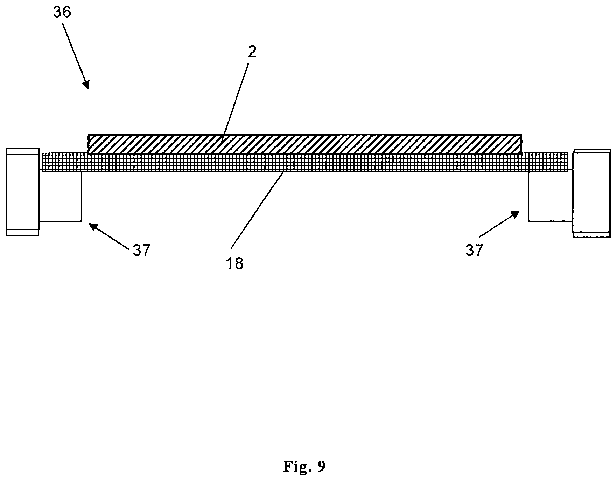

In Fig. 9 ist die erfindungsgemäße Transporteinrichtung 36 für die Behandlungskammer 3 in der erfindungsgemäßen Vorrichtung 1 abgebildet. Die Transportvorrichtung 36 weist seitlich angebrachte Rollen 37 in regelmäßigen Abständen auf, die den Substratträger 18 bzw. das Substrat 2 selbst (nicht gezeigt) stützen, so dass es durch die Vorrichtung transportiert werden kann.

Folgende optionale, nicht dargestellte Merkmale können für weitere vorteilhafte Verbesserung eingesetzt werden:
1. Metallische Reflektoren für die Strahlungsheizer 10 auf der kammerabgewandten Seite.
2. Verkleidungen und Beschichtungen des Kammerraumes 16, 16a, 16b, 16c, 16d, die eine Belegung oder einen Korrosionsangriff mit korrosiven Gasen und Dämpfen verhindern.
3. Eine auf mittlere Temperaturen beheizte Kammerwand 4, 5, 6, 7, die eine Belegung mit flüchtigen Komponenten verhindert.
4. Die Hintereinanderschaltung mehrerer identischer oder ähnlicher Behandlungskammern 3 des gezeigten Aufbaus, wobei nach einer Teilprozesszeit das zu behandelnde Substrat 2 schnell in die nächste Kammer 3 weiter geschoben wird.
5. Einschleusung zweier oder mehrerer Substrate 2 nebeneinander oder hintereinander in die Behandlungskammer 3, wozu entweder eine große oder mehrere kleine Prozesshauben 11, 11a, 11b, 11c, 11d in einem großen Kammerraum nebeneinander realisiert werden. Die gleichzeitige Einschleusung von mehreren Substraten 2 nebeneinander oder hintereinander unter einer großen oder mehreren kleineren Prozesshauben 11, 11a, 11b, 11c, 11d empfiehlt sich, wenn eine bestimmte Taktzeit pro Gesamtanlage erreicht werden soll, aber der Prozess die Öffnung der Haube 11, 11a, 11b, 11c, 11d innerhalb einer bestimmten Heizphase nicht erlaubt.
6. Nachgeschaltete Kühlkammern 34 oder eine Kühlstrecke zur Abkühlung des prozessierten Substrats 2.
7. Vorrichtungen für Spülgaseinlass und Druckgradienten gemäß WO 01/29901 A2.
8. Vorgeschaltete Vakuumein- und nachgeschaltete -ausschleuskammern um semikontinuierlich das Einführen neuer Substrate 2 und das Ausführen der fertigprozessierten Substrate 2 ohne Unterbrechung der reinen Prozessbedingungen (z.B. O₂/H₂O-Konzentration) zu ermöglichen.

Im Folgenden wird ein Beispiel für einen erfindungsgemäßen Prozessablauf gegeben. Dabei erfolgen nacheinander:
1. Einschleusen des Substrates 2 (mit oder ohne Carrier 18) in eine Behandlungskammer 3 durch eine oder mehrere Einschleuskammern.
2. Herstellung der erforderlichen Umgebungsatmosphäre durch Abpumpen und/oder Spülen.
3. Positionierung des Substrats 2 unter der ersten Prozesshaube 11.
4. Absenkung der Prozesshaube 11 zur Herstellung des Prozessraums 17 über der beschichteten Oberfläche 15 des Substrats 2.
5. Gegebenenfalls Einlass eines Reaktionsgasgemisches in den Prozessraum 17.
6. Aufheizen des Substrats 2 mit gewünschten Temperatur- und Prozessgasparametern über die Strahlungsquellen 10.
7. Hebung der Prozesshaube 11 und Weitertransport des Substrats 2 (mit oder ohne Carrier 18), wobei auch zwei oder mehrere Substrate 2 simultan parallel oder hintereinander eingeschleust werden können.
8. Gegebenenfalls erfolgt der in Schritt 7 bezeichnete Weitertransport in eine weitere Behandlungskammer 3 unter Wiederholung der Schritte 3 bis 7 sowie vorher gegebenenfalls von Schritt 2.
9. Transport des beschichteten Substrats 2 ohne Einhausung in eine Kühlstrecke oder eine oder mehrere Kühlkammern 34.
10. Ausschleusung des beschichteten Substrats 2 durch Ausschleuskammern.
11. Nachkühlen des Substrates 2 bis zur gewünschten Endtemperatur.

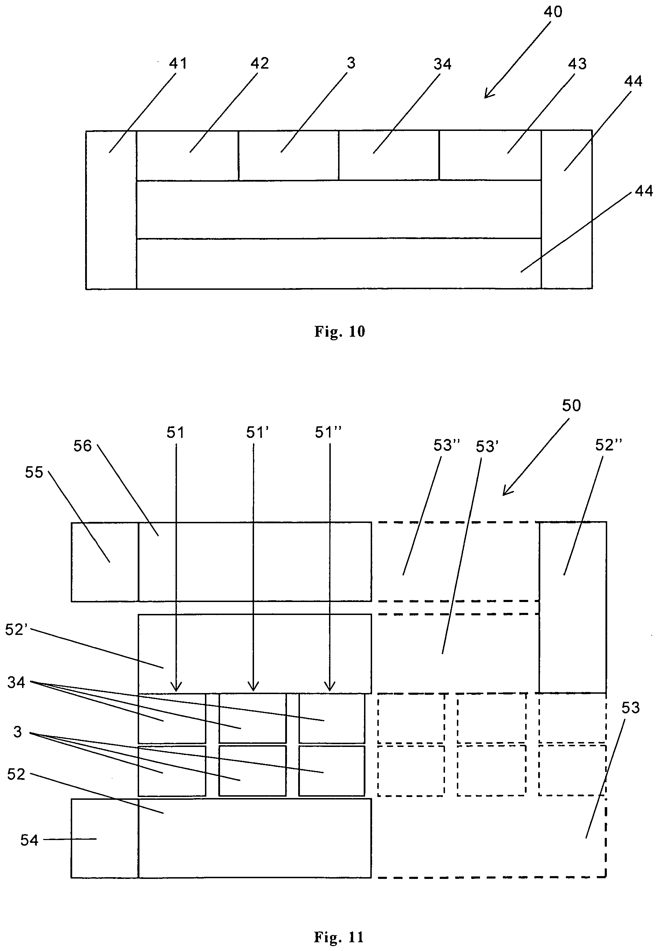

In den Fig. 10 und 11 sind rein schematisch die zwei Ausführungsformen von Gesamtanlagen 40, 50 dargestellt, in die die erfindungsgemäße Vorrichtung 1 integriert ist. Dabei weist die Gesamtanlage 40 gemäß Fig. 10 einen Handlingbereich 41 auf, der das Interface zwischen den vorausgehenden- und nachfolgenden Prozessschritten sowie zur Prozessstrecke bildet. Die Eingangstür-/schleuse 42 ist zur Herstellung der erforderlichen Umgebungs-/Prozessatmosphäre vorgesehen. Die Behandlungskammer 3 dient der Durchführung des erfindungsgemäßen Temperprozesses. Die Kühlkammer 34 dient der Abkühlung der Substrate 2 mit oder ohne Carrier 18. Mit Hilfe der Ausgangstür-/schleuse 43 wird die erforderliche Umgebungs-/Prozessatmosphäre hergestellt. Schließlich ist eine Quer-/Rückförderstrecke 44 vorgesehen, die dem Rücktransport der Substrate 2 bzw. der Substrate 2 und Carrier 18 in den Handlingbereich 41 sowie der Abkühlung der Substrate 2 mit oder ohne Carrier 18 dient. Dabei können die einzelnen Bereiche 41, 42, 34, 43 oder 44 teilweise oder ganz entfallen, z.B. wenn die Anlage 40 mit entsprechenden vorausgehenden- oder nachfolgenden Anlagen (nicht gezeigt) verbunden wird.

Bei der in Fig. 11 gezeigten weiteren Ausführungsform der Gesamtanlage 50 auf Basis des beschriebenen Konzepts der Prozesshauben 1, 11a, 11b, 11c, 11d werden parallele Prozessstrecken 51, 51', 51", bestehend aus den Behandlungskammern 3 und optional den Kühlkammern 34 für die Abkühlung unmittelbar nach Beendigung des Temperprozesses aufgebaut und von beiden Seiten über Transferkammern 52, 52' be- und entladen. Vorteil dieser Anordnung ist die Modularität, d.h. diese Anordnung kann über Verlängerungsmodule 53, 53', 53" um weitere Prozessstrecken erweitert werden, wie anhand der schraffierten Bereiche zu erkennen ist. Weiterhin sind wiederum Eingangstür-/schleuse 54 und Ausgangstür-/schleuse 55 vorgesehen wobei zwischen den Prozessstrecken 51, 51', 51" und der Ausgangstür-/schleuse 55 eine weitere Transferkammer 52" und ein zusätzlicher Kühltunnel 56 angeordnet sind.

Aus den vorstehenden Darstellungen ist deutlich geworden, dass eine Vorrichtung und ein Verfahren zur Temperierung von Gegenständen bereitgestellt werden, die die Nachteile bisher bekannter Temperierungen überwinden, wobei insbesondere eine hohe Reproduzierbarkeit und ein hoher Durchsatz der Temperierung erreicht wird, bei gleichzeitig geringen Investitionskosten, so dass der Prozess der Temperierung insgesamt sehr kostengünstig realisiert wird.

## Patentansprüche

1. Vorrichtung (1) zum Tempern zumindest eines Gegenstands, insbesondere eines Mehrschichtkörpers mit mindestens zwei Schichten, mit einer Behandlungskammer (3) mit einem Kammerraum (17), mindestens einer Energiequelle (10) und einer Prozesshaube (11), die einen Prozessraum (16) definiert, in dem der Gegenstand (2, 15) zumindest teilweise angeordnet wird, wobei die Prozesshaube (11) das Volumen des Prozessraumes (16), in dem zumindest ein Teil des Gegenstands (2, 15) temperiert wird, gegenüber dem Volumen des Kammerraumes (17) reduziert,
**dadurch gekennzeichnet, dass** die Prozesshaube (11) zumindest als stationär in der Behandlungskammer (3) angeordneter Deckel (12) ausgebildet ist und
der Deckel (12) einen umlaufenden Rahmen (13) aufweist, der so dimensioniert ist, dass der Gegenstand (2, 15) oder ein den Gegenstand (2, 15) stützender Träger (18) von dem Rahmen (13) umhüllbar ist, wobei der Rahmen (13) 1, gegenüber dem Gegenstand (2, 15) bzw. dem Träger (18) seitlich verschiebbar angeordnet ist, und wobei die Prozesshaube (11) gegenüber dem Gegenstand (2, 15) vertikal verschiebbar angeordnet ist, wobei ein Abstand zwischen dem Deckel (12) und dem Gegenstand (2, 15) durch vertikale Bewegung des Deckels (12) zum Gegenstand (2, 15) einstellbar ist.

2. Vorrichtung (1) nach Anspruch 1, **dadurch gekennzeichnet, dass** der Abstand zwischen einer Oberseite des Gegenstandes (2, 15) und einer Unterseite des Deckels (12) kleiner als 50 mm, bevorzugt kleiner als 10 mm ist.

3. Vorrichtung nach einem der vorherigen Ansprüche, **dadurch gekennzeichnet, dass** die als Deckel (12) ausgebildete Prozesshaube und der Gegenstand (2, 15) oder der Träger (18) dazu ausgebildet sind eine Gasaustauschbarriere auszubilden, die den Gasaustausch zwischen dem Prozessraum und dem Kammerraum reduziert, wobei die Gasaustauschbarriere durch einen Abstand zwischen dem Deckel (12) und dem Gegenstand (2, 15) oder dem Träger (18) einstellbar ist.

4. Vorrichtung nach einem der vorherigen Ansprüche, **dadurch gekennzeichnet, dass** der Prozessraum, der durch die als Deckel (12) ausgebildete Prozesshaube und den Gegenstand (2, 15) oder den Träger (18) gebildet ist, einen Druckausgleichswiderstand zum Kammerraum ausbildet.

5. Vorrichtung nach einem der Ansprüche 1 bis 3, **dadurch gekennzeichnet, dass** die als Deckel (12) ausgebildete Prozesshaube und der Gegenstand oder der Träger derart ausgebildet sind, dass der Prozessraum, der durch die als Deckel (12) ausgebildete Prozesshaube und den Gegenstand (2, 15) oder den Träger (18) ausgebildet ist, gasdicht abgedichtet ist.

6. Vorrichtung nach einem der vorherigen Ansprüche, **dadurch gekennzeichnet, dass** die als Deckel ausgebildete Prozesshaube (11d) zumindest einen Gaseinlass (29) und/oder zumindest einen Gasauslass aufweist, wobei die als Deckel ausgebildete Prozesshaube bevorzugt zumindest einen zweidimensional ausgebildeten Gasverteiler (27) aufweist.

7. Vorrichtung (1) nach einem der vorherigen Ansprüche, **dadurch gekennzeichnet, dass** die Energiequelle (10) außerhalb des Kammerraumes (17) angeordnet ist, bevorzugt als Strahlungsquelle (10) für elektromagnetische Strahlung und insbesondere als punktförmige Strahlungsquelle oder Anordnung mehrerer punktförmiger Strahlungsquellen (10) ausgebildet ist, wobei die Strahlungsquelle bevorzugt mit einem Reflektor auf der der Reaktionskammer der Strahlungsquelle abgewandten Seite versehen ist.

8. Vorrichtung (1) nach einem der vorherigen Ansprüche, **dadurch gekennzeichnet, dass** die als Deckel (12) ausgebildete Prozesshaube (11) zumindest teiltransparent für elektromagnetische Strahlung ausgebildet ist und/oder zumindest eine Wand (4, 5) der Behandlungskammer (3) zumindest bereichsweise zumindest teiltransparent für elektromagnetische Strahlung ausgebildet ist, wobei in der Wand bevorzugt zumindest teiltransparent für elektromagnetische Strahlung ausgebildete Segmente in einem Stützrahmen aufgenommen sind.

9. Vorrichtung (1) nach einem der vorherigen Ansprüche, **dadurch gekennzeichnet, dass** zumindest eine Wand der Behandlungskammer mit einer Beschichtung und/oder Verkleidung versehen ist, die dazu ausgebildet ist/sind, eine Belegung der Kammerwand oder die Einwirkung von korrosiven Gasen und Dämpfen auf sie im Wesentlichen verhindern, wobei die Kammerwand bevorzugt so heizbar ausgerüstet ist, dass eine Belegung mit flüchtigen Komponenten im Wesentlichen verhindert wird.

10. Vorrichtung (1) nach einem der vorherigen Ansprüche, **dadurch gekennzeichnet, dass** die Behandlungskammer ausgelegt ist, zwei oder mehrere Gegenstände gleichzeitig zu tempern, wobei entweder eine gemeinsame als Deckel ausgebildete Prozesshaube oder für jeden Gegenstand eine eigene als Deckel ausgebildete Prozesshaube vorgesehen ist.

11. Vorrichtung (1) nach einem der vorherigen Ansprüche, **dadurch gekennzeichnet, dass** zumindest zwei Behandlungskammern zum Tempern in Transportrichtung des Gegenstandes hintereinander angeordnet sind und/oder dass zumindest eine Einrichtung (35) zum Kühlen des Gegenstandes (2, 15) vorgesehen ist, die bevorzugt in einer von der Behandlungskammer (3) unabhängigen Kühlkammer (34) angeordnet ist.

12. Vorrichtung nach einem der vorherigen Ansprüche, **dadurch gekennzeichnet, dass** in Gasdurchtrittsrichtung zwischen Prozessraum und Kammerraum ein Pufferraum angeordnet ist, wobei der Kammerraum einen Spülgaseinlass und der Pufferraum einen Gasauslass aufweisen, wobei der Gasauslass aus dem Pufferraum angepasst ist, Gas direkt und unter Umgehung des Kammerraumes aus der Behandlungskammer abzuleiten.

13. Verfahren zum Tempern eines Mehrschichtkörpers (2, 15) mit mindestens zwei Schichten, in einer Behandlungskammer (3) mit einem Kammerraum (17), unter Verwendung einer Vorrichtung (1) zum Tempern nach einem der vorherigen Ansprüche, wobei der Mehrschichtkörper (2, 15) in die Behandlungskammer (3) verbracht und zumindest bereichsweise einer Energiequelle (10) ausgesetzt wird, wobei zumindest bereichsweise um den Mehrschichtkörper (2, 15) ein Prozessraum (16) angeordnet ist, der kleiner als der Kammerraum (17) ist, **dadurch gekennzeichnet, dass** der Prozessraum (16) erst im Inneren der Behandlungskammer (3) ausgebildet wird.

14. Verfahren nach Anspruch 13, **dadurch gekennzeichnet, dass** durch den Prozessraum (16), der durch die als Deckel ausgebildete Prozesshaube (22) und den Mehrschichtkörper (2, 15) oder den Träger (18) ausgebildet ist, ein Druckausgleichswiderstand zum Kammerraum (17) ausgebildet wird.

15. Verfahren nach Anspruch 13 oder 14, **dadurch gekennzeichnet, dass** in Gasdurchtrittsrichtung zwischen Prozessraum und Kammerraum ein Pufferraum angeordnet ist und ein Spülgas in den Kammerraum eingelassen wird, wobei der Gasdruck des Spülgases größer ist als der Gasdruck der Prozessgase und Prozessreaktionsgase im Prozessraum und aus dem Pufferraum eventuell austretendes Gas mittels eines Gasauslasses unter Umgehung des Kammerraums direkt aus der Behandlungskammer abgeleitet wird.

## Claims

1. Device (1) for the tempering of at least one object, in particular, of a multilayer body with at least two layers, with a treatment chamber (3) with a chamber space (17), at least one energy source (10), and a processing hood (11) that defines a processing space (16) in which the object (2, 15) can be at least partially disposed, wherein the processing hood (11) reduces the volume of the processing space (16) in which at least a part of the object (2, 15) is tempered, compared to the volume of the chamber space (17),
**characterized in that** the processing hood (11) is designed at least as a cover (12) disposed stationarily in the treatment chamber (3) and the cover (12) has a circumferential frame (13) dimensioned such that the object (2, 15) or a carrier (18) supporting the object (2, 15) can be encased on the sides, with the frame (13) displaceably disposed laterally relative to the object (2, 15) or the carrier (18), and wherein the processing hood (11) is disposed vertically displaceably relative to the object (2, 15), wherein a distance between the cover (12) and the object (2, 15) can be adjusted by vertical movement of the cover 12 toward the object (2, 15).

2. Device (1) according to claim 1, **characterized in that** the distance between a top of the object (2, 15) and a bottom of the cover (12) is smaller than 50 mm, preferably smaller than 10 mm.

3. Device according to one of the preceding claims, **characterized in that** the processing hood embodied as cover (12) and the object (2, 15) or the carrier (18) are configured form a gas exchange barrier, which reduces the gas exchange between the processing space and the chamber space, wherein the gas exchange barrier can be adjusted by a distance between the cover (12) and the object (2, 15) or the carrier (18).

4. Device according to one of the preceding claims, **characterized in that** the processing space that is formed by the processing hood embodied as cover (12) and the object (2, 15) or the carrier (18) forms pressure equalization resistance relative to the chamber space.

5. Device according to one of the claims 1 through 3, **characterized in that** the processing hood embodied as cover (12) and the object or the carrier are configurd such that the processing space that is formed by the processing hood embodied as cover (12) and the object (2, 15) or the carrier (18) is sealed essentially gas tight.

6. Device according to one of the preceding claims, **characterized in that** the processing hood (11d) embodied as cover has at least one gas inlet (29) and/or at least one gas outlet, whereby the processing hood embodied as cover preferably has at least one two-dimensionally designed gas sparger (27).

7. Device (1) according to one of the preceding claims, **characterized in that** the energy source (10) is disposed outside the chamber space (17), preferably as a radiation source (10) for electromagnetic radiation and is designed, in particular, as a punctiform radiation source or arrangement of a a plurality of punctiform radiation sources (10), whereby the radiation source is preferably provided with a reflector on the side turned away from the reaction chamber of the radiation source.

8. Device (1) according to one of the preceding claims, **characterized in that** the processing hood (11) embodied as cover (12) is designed at least partially transparent to electromagnetic radiation and/or at least one wall (4, 5) of the treatment chamber (3) is designed at least zone-wise at least partially transparent to electromagnetic radiation, whereby, in the wall, segments preferably designed at least partially transparent to electromagnetic radiation are accommodated in a support frame.

9. Device (1) according to one of the preceding claims, **characterized in that** at least one wall of the treatment chamber is provided with a coating and/or lining that essentially prevents cladding of the chamber wall or action of corrosive gases and vapors thereon, whereby the chamber wall is preferably heatably equipped such that cladding with volatile components is essentially prevented.

10. Device (1) according to one of the preceding claims, **characterized in that** the treatment chamber is designed to temper two or more objects simultaneously, whereby either a common processing hood embodied as cover or a dedicated processing hood embodied as cover for each object is provided.

11. Device (1) according to one of the preceding claims, **characterized in that** at least two treatment chambers for tempering are disposed sequentially in the transport direction of the object and/or that at least one installation (35) is provided for cooling the object (2, 15), which installation is disposed in a cooling chamber (34) independent of the treatment chamber (3).

12. Device according to one of the preceding claims, **characterized in that** in the gas passage direction between the processing space and the chamber space, a buffer space is arranged, whereby the chamber space has a purging gas inlet and the buffer space has a gas outlet, whereby the gas outlet out of the buffer space is adapted to discharge gas directly out of the treatment chamber, bypassing the chamber space.

13. Method for tempering a multilayer body (2, 15) with at least two layers, in a treatment chamber (3) with a chamber space (17) with the use of a device (1) for tempering according to one of the preceding claims, whereby the multilayer body (2, 15) is brought into the treatment chamber (3) and is exposed at least zone-wise to an energy source (10), whereby a processing space (16) is disposed at least zone-wise around the multilayer body (2, 15), which processing space is smaller than the chamber space (17), **characterized in that** the processing space (16) is formed only in the interior of the treatment chamber (3).

14. Method according to claim 13, **characterized in that** by the processing space (16) formed by the process hood (11) embodied as cover and the multilayer body a pressure equalization resistance to the chamber space (17) is formed.

15. Method according to claim 13 or 14, **characterized in that** a buffer space is disposed in the gas passage direction between the processing space and the chamber space and a purging gas is let into the chamber space, whereby the gas pressure of the purging gas is greater than the gas pressure of the process gases and the process reaction gases in the processing space and gas possibly escaping from the buffering space is discharged by means of a gas outlet directly out of the treatment chamber, bypassing the chamber space.

## Revendications

1. Dispositif (1) pour recuire au moins un objet, en particulier un corps multicouche avec au moins deux couches, avec une chambre de traitement (3) avec un espace de chambre (17), au moins une source d'énergie (10) et un capot de traitement (11), qui définit un espace de traitement (16), dans lequel l'objet (2, 15) est au moins partiellement disposé, où le capot de traitement (11) réduit le volume de l'espace de traitement (16), dans lequel au moins une partie de l'objet (2, 15) est recuit, par rapport au volume de l'espace de chambre (17),
**caractérisé en ce que** le capot de traitement (11) est conçu au moins comme un couvercle (12) disposé de manière fixe dans la chambre de traitement (3) et le couvercle (12) présente un cadre périphérique (13) qui est dimensionné de telle manière que l'objet (2, 15) ou un support (18) supportant l'objet (2, 15) peut être entouré par le cadre (13), où le cadre (13) est disposé de manière à pouvoir être déplacé latéralement par rapport à l'objet (2, 15) ou au support (18), et où le capot de traitement (11) est disposée de manière à pouvoir être déplacée verticalement par rapport à l'objet (2, 15), où une distance entre le couvercle (12) et l'objet (2, 15) peut être réglée par un mouvement vertical du couvercle (12) par rapport à l'objet (2, 15).

2. Dispositif (1) selon la revendication 1, **caractérisé en ce que** la distance entre une face supérieure de l'objet (2, 15) et une face inférieure du couvercle (12) est inférieure à 50 mm, de préférence inférieure à 10 mm.

3. Dispositif selon l'une des revendications précédentes, **caractérisé en ce que** le capot de traitement conçu comme un couvercle (12) et l'objet (2, 15) ou le support (18) sont conçus pour former une barrière d'échange de gaz qui réduit l'échange de gaz entre l'espace de traitement et l'espace de la chambre, où la barrière d'échange de gaz peut être réglée par une distance entre le couvercle (12) et l'objet (2, 15) ou le support (18).

4. Dispositif selon l'une des revendications précédentes, **caractérisé en ce que** la chambre de traitement, qui est formée par le capot de traitement conçu comme un couvercle (12) et l'objet (2, 15) ou le support (18), forme une barrière d'égalisation de pression à l'espace de chambre.

5. Dispositif selon l'une des revendications 1 à 3, **caractérisé en ce que** le capot de traitement, qui est conçu comme un couvercle (12), et l'objet ou le support sont conçus de telle manière que l'espace de traitement, qui est formée par le capot de traitement conçu en tant que couvercle (12) et l'objet (2, 15) ou le support (18), est fermée de manière étanche aux gaz.

6. Dispositif selon l'une des revendications précédentes, **caractérisé en ce que** le capot de traitement (11d) conçu comme un couvercle présente au moins une entrée de gaz (29) et/ou au moins une sortie de gaz, où le capot de traitement conçu comme un couvercle présente de préférence au moins un distributeur de gaz (27) conçu en deux dimensions.

7. Dispositif (1) selon l'une des revendications précédentes, **caractérisé en ce que** la source d'énergie (10) est disposée à l'extérieur de l'espace de chambre (17), est de préférence conçu comme source de rayonnement (10) au rayonnement électromagnétique et en particulier comme source de rayonnement en forme de points ou comme disposition de plusieurs sources de rayonnement en forme de points (10), où la source de rayonnement est de préférence pourvue d'un réflecteur sur le côté opposé à la chambre de réaction de la source de rayonnement.

8. Dispositif (1) selon l'une des revendications précédentes, **caractérisé en ce que** le capot de traitement (11), conçu comme un couvercle (12), est conçu au moins partiellement transparent au rayonnement électromagnétique et/ou au moins une paroi (4, 5) de la chambre de traitement (3) est conçue au moins partiellement transparente au rayonnement électromagnétique au moins dans certaines régions, où des segments construits de préférence au moins partiellement transparents au rayonnement électromagnétique sont reçus dans la paroi dans un cadre de support.

9. Dispositif (1) selon l'une des revendications précédentes, **caractérisé en ce qu'**au moins une paroi de la chambre de traitement est pourvue d'un revêtement et/ou d'un habillage qui est/sont conçu(s) pour empêcher essentiellement l'occupation de la paroi de la chambre ou l'effet des gaz et vapeurs corrosifs sur celle-ci, où la paroi de la chambre peut de préférence être chauffée pour empêcher essentiellement une occupation par des composants volatils.

10. Dispositif (1) selon l'une des revendications précédentes, **caractérisé en ce que** la chambre de traitement est conçue pour recuire deux ou plusieurs objets simultanément, dans lequel il est prévu soit un capot de traitement commune conçu comme un couvercle, soit pour chaque objet un capot de traitement séparée conçu comme un couvercle.

11. Dispositif (1) selon l'une des revendications précédentes, **caractérisé en ce qu'**au moins deux chambres de traitement pour recuire sont disposées l'une derrière l'autre dans le sens de transport de l'objet et/ou qu'il est prévu au moins un dispositif (35) pour le refroidissement de l'objet (2, 15), qui est disposé de préférence dans une chambre de refroidissement (34) indépendante de la chambre de traitement (3).

12. Dispositif selon l'une des revendications précédentes, **caractérisé en ce qu'**un espace tampon est disposé dans la direction de passage du gaz entre la chambre de traitement et l'espace de la chambre, où l'espace de la chambre a une entrée de gaz de purge et l'espace tampon a une sortie de gaz, où la sortie de gaz de l'espace tampon est adaptée pour évacuer le gaz directement et en contournant l'espace de la chambre de traitement.

13. Procédé pour recuire un corps multicouche (2, 15) ayant au moins deux couches, dans une chambre de traitement (3) avec un espace de chambre (17), en utilisant un dispositif (1) pour recuire selon l'une des revendications précédentes, où le corps multicouche (2, 15) est amené dans la chambre de traitement (3) et est exposé au moins par régions à une source d'énergie (10) où au moins par endroits autour du corps multicouche (2, 15), une chambre de traitement (16) est disposée qui est plus petite que l'espace de chambre (17), **caractérisé en ce que** chambre de traitement (16) est conçue uniquement à l'intérieur de la chambre de traitement (3).

14. Procédé selon la revendication 13, **caractérisé en ce qu'**une résistance de compensation de pression à l'espace de la chambre (17) est formée par l'espace de traitement (16) formé par le capot de traitement (22), conçu comme un couvercle, et le corps multicouche (2, 15) ou le support (18).

15. Procédé selon la revendication 13 ou 14, **caractérisé en ce qu'**un espace tampon est disposé dans la direction de passage du gaz entre l'espace de traitement et l'espace de la chambre et un gaz de purge est admis dans l'espace de la chambre, où la pression du gaz de purge est supérieure à la pression des gaz de traitement et des gaz de réaction de traitement dans l'espace de traitement, et tout gaz s'échappant de l'espace tampon est évacué directement de la chambre de traitement au moyen d'une sortie de gaz, en contournant l'espace de la chambre.
